# EUROPÄISCHE PATENTSCHRIFT

(11) **EP 3 710 987 B1**
(45) Veröffentlichungstag und Bekanntmachung des Hinweises auf die Patenterteilung: **17.05.2023**
(21) Anmeldenummer: 19706888.5
(22) Anmeldetag: 06.02.2019
(51) Int. Cl.: G06K 19/06

(54) **VERFAHREN ZUM HERSTELLEN EINES MIT EINEM CODE VERSEHENEN BAUTEILS SOWIE BAUTEIL MIT EINEM CODE**
METHOD FOR PRODUCING A COMPONENT PROVIDED WITH A CODE, AND COMPONENT HAVING A CODE
PROCÉDÉ DE PRODUCTION D'UN COMPOSANT POURVU D'UN CODE AINSI QUE COMPOSANT POURVU D'UN CODE

(30) Priorität: 20.03.2018 DE 102018204259
(43) Veröffentlichungstag der Anmeldung: 23.09.2020
(73) Patentinhaber: Siemens Energy Global GmbH & Co. KG, 81739 München (DE)
(72) Erfinder: GEISEN, Ole, 10781 Berlin (DE); LENZEN, Thomas, 52062 Aachen (DE)
(86) Internationale Anmeldenummer: PCT/EP2019/052843
(87) Internationale Veröffentlichungsnummer: WO 2019/179689

(56) Entgegenhaltungen:
- WO-A1-03/058544
- DE-A1-102009 043 317
- DE-A1-102012 018 388
- DE-A1-102014 104 196
- DE-U1-202017 105 458
- US-A1- 2015 145 158

## Beschreibung

Die vorliegende Erfindung betrifft ein Verfahren, bei dem ein dreidimensionales Bauteil hergestellt und auf seiner Bauteiloberfläche mit einem maschinenlesbaren Code versehen wird. Ferner betrifft die Erfindung ein Bauteil mit einem solchen Code.

Im Stand der Technik ist es bekannt, Bauteile nach ihrer Herstellung mit einem Code zu versehen, der als Identifikator für das Bauteil dient. Neben der Bauteilidentifikation kann ein solcher Code auch dazu dienen, weitere Informationen zum Bauteil zu hinterlegen, insbesondere Hinweise auf die Produktionsbedingungen des Bauteils, um auf diese Weise eine möglichst genaue Bauteilrückverfolgung zu ermöglichen.

Das am weitesten verbreitete Beispiel eines solchen Codes ist die sogenannte Seriennummer, bei der es sich um eine eindeutige alphanumerische Bezeichnung handelt. Eine solche Seriennummer ist meist dreidimensional gestaltet und dauerhaft am Bauteil angebracht, beispielsweise in Form einer Gravur. Ein Nachteil einer solchen Seriennummer besteht darin, dass das Bauteil erst nach seiner Herstellung mit einer solchen versehen wird, was einen zusätzlichen Arbeitsschritt bedeutet. Auch kann ein Bauteil versehentlich mit einer falschen Seriennummer gekennzeichnet werden. Zudem ist das maschinelle Auslesen von Seriennummern nur mit aufwändigen technischen Mitteln realisierbar, was nicht wünschenswert ist.

Alternativ zu der Seriennummer werden zweidimensional gestaltete Codes zur Kennzeichnung von Bauteilen verwendet, insbesondere Strichcodes, welche die codierten Daten binär in Form von schwarzen Strichen auf weißem Untergrund darstellen, und QR-Codes, die aus einer quadratischen Matrix aus schwarzen und weißen Quadraten gebildet sind, welche die codierten Daten binär darstellen. Ein wesentlicher Vorteil von Strichund QR-Codes besteht darin, dass sie maschinenlesbar sind. Besonders der QR-Code erfreut sich wachsender Beliebtheit, da sich zum einen eine große Anzahl von Informationen auf kleiner Fläche darstellen lässt. Zum anderen lässt er sich unter Einsatz weit verbreiteter technischer Geräte auslesen, wie beispielsweise mit einem Smartphone, das mit einer entsprechenden Auslesesoftware versehen ist. Ein gravierender Nachteil von Strich- und QR-Codes besteht allerdings darin, dass sie in einem separaten Verfahrensschritt auf die Bauteiloberfläche aufgebracht werden müssen. Hierbei können insbesondere Zuordnungsfehler auftreten. Abhängig von der Art des Codes und seiner Anbringung an der Bauteiloberfläche ist auch ein nachträgliches Ablösen oder widerrechtliches Austauschen des Codes nicht auszuschließen.

WO03058544 A1 bezieht sich auf ein Verfahren, welches 3-D Repräsentationen einer Markierung herstellt.

DE102009043317 A1 bezieht sich auf ein Verfahren zum generativen Herstellen eines dreidimensionalen Objekts. Dabei wird ein Pulvermaterial auf einer zuvor aufgetragenen Schicht schichtweise aufgetragen. Das Pulvermaterial wird so verfestigt, dass ein digitales, maschinenlesbares und dreidimensional kodiertes Zeichen an einer Fläche des Objekts vorgesehen wird.

Ausgehend von diesem Stand der Technik ist es eine Aufgabe der vorliegenden Erfindung, ein alternatives Verfahren der eingangs genannten Art zu schaffen. Die Erfindung ist in den unabhängigen Ansprüchen definiert.

Zur Lösung dieser Aufgabe schafft die vorliegende Erfindung ein Verfahren der eingangs genannten Art, das dadurch gekennzeichnet ist, dass der Code einteilig mit dem Bauteil hergestellt wird und eine Vielzahl von dreidimensional gestalteten Code-Elementen aufweist, welche die codierten Daten binär anhand von bezogen auf eine Bezugsebene erhabenen Bereichen und nicht-erhabenen Bereichen darstellen.

Alternativ oder zusätzlich wird die zuvor genannte Aufgabe erfindungsgemäß durch ein Verfahren der eingangs genannten Art gelöst, das dadurch gekennzeichnet ist, dass der Code einteilig mit dem Bauteil hergestellt wird und eine Vielzahl von dreidimensional gestalteten Code-Elementen aufweist, welche die codierten Daten binär anhand von bezogen auf eine Bezugsebene vertieften Bereichen und nicht-vertieften Bereichen darstellen.

Die einteilige Ausbildung von Code und Bauteil ist dahingehend von Vorteil, dass der Code dauerhaft mit dem Bauteil verbunden ist und entsprechend nicht ohne weiteres entfernt oder ausgetauscht werden kann. Darüber hinaus können Bauteil und Code grundsätzlich in einem Arbeitsgang auf derselben Fertigungsmaschine gefertigt werden, so dass eine fehlerhafte Zuordnung ausgeschlossen werden kann.

Vorteilhaft sind die Code-Elemente in einer Reihen und Spalten definierenden Matrix angeordnet, insbesondere analog zu einem QR-Code. Entsprechend kann der erfindungsgemäße Code ähnlich oder genauso wie ein herkömmlicher QR-Code ausgelesen werden.

Bevorzugt weisen die Code-Elemente entweder eine einer ganzzahligen Quadratzahl entsprechende Anzahl von in einer regelmäßigen Matrix angeordneten erhabenen Bereichen bzw. von vertieften Bereichen auf oder sie bestehen aus einem einzelnen nicht-erhabenen Bereich bzw. nicht-vertieften Bereich. Im einfachsten Fall kann also ein Code-Element durch einen einzelnen erhabenen bzw. vertieften Bereich oder durch einen einzelnen nicht-erhabenen bzw. nicht-vertieften Bereich gebildet werden. Alternativ ist es aber auch möglich, dass ein Code-Element durch mehrere erhabene bzw. vertiefte Bereiche gebildet wird, die insbesondere in einer quadratischen Anordnung angeordnet sind. Dies kann ggf. die Lesbarkeit des Codes verbessern bzw. die Fehleranfälligkeit verringern.

Gemäß einer Ausgestaltung der vorliegenden Erfindung werden das Bauteil und der Code aus dem gleichen Ausgangswerkstoff hergestellt, wodurch insbesondere die Fertigung vereinfacht wird.

Zur Erhöhung des Kontrastes zwischen den erhabenen Bereichen bzw. den vertieften Bereichen und den nicht-erhabenen bzw. den nicht-vertieften Bereichen sind die erhabenen bzw. vertieften Bereiche vorteilhaft pyramidenförmig, pyramidenstumpfförmig, kegelförmig, kegelstumpfförmig oder kugelsegmentförmig ausgebildet sind, wobei unter pyramidenförmig vorliegend jeder gleichmäßig ausgebildete Körper mit zumindest drei spitz zulaufenden Seitenflächen verstanden wird. Derart ausgebildete erhabene bzw. vertiefte Bereiche reflektieren einfallendes Licht anders als die nicht-erhabenen bzw. nicht-vertieften Bereiche, wodurch der Kontrast zwischen den verschieden ausgebildeten Code-Elementen und damit die Lesbarkeit des Codes deutlich verbessert wird.

Gemäß der vorliegenden Erfindung werden das Bauteil und der Code auf Basis eines 3D-CAD-Datensatzes schichtweise auf einer additiven Fertigungsmaschine gefertigt, wobei der 3D-CAD-Datensatz die Geometrie des Bauteils definierende Daten, die Position des Codes auf der Bauteiloberfläche betreffende Daten und die Geometrie des Codes betreffende Daten aufweist oder aus diesen Daten besteht. Bei der additiven Fertigungsmaschine kann es sich grundsätzlich um jede Fertigungsmaschine handeln, auf der sich ein Bauteil aus einem Ausgangswerkstoff schichtweise fertigen lässt. So kann die additive Fertigungsmaschine beispielsweise dazu ausgelegt sein, ein Photopolymerisationsverfahren, ein SLM-Verfahren (Selective Laser Melting), ein SLS-Verfahren (Selective Laser Sintering) oder dergleichen durchzuführen.

Dabei werden das Bauteil und der Code auf Basis eines 3D-CAD-Datensatzes schichtweise auf einer additiven Fertigungsmaschine gefertigt, wobei der 3D-CAD-Datensatz die Geometrie des Bauteils definierende Daten und die Position des Codes auf der Bauteiloberfläche betreffende Daten aufweist oder aus diesen Daten besteht, und wobei dem 3D-CAD-Datensatz vor der additiven Fertigung die Geometrie des Codes betreffende Daten durch eine CAM-Software hinzugefügt werden. So bleibt der 3D-CAD-Datensatz unabhängig vom Code stets unverändert.

Wird das Bauteil in Serie gefertigt, so werden nach der Fertigung jedes Bauteils bevorzugt ausschließlich die Geometrie des Codes betreffende Daten geändert. Mit anderen Worten werden bei Serienbauteilen die Geometrie des Bauteils definierenden Daten und die Position des Codes auf der Bauteiloberfläche betreffenden Daten jeweils für alle Bauteile der Serie übernommen, während nur diejenigen Daten ausgetauscht werden, welche die Geometrie des Codes betreffen. Auf diese Weise wird die Generierung der Codes in der Serienfertigung vereinfacht, wodurch insbesondere Rechenleistung eingespart werden kann.

Ferner schafft die vorliegende Erfindung ein Bauteil, das - beispielsweise mittels des oder der beschriebenen Verfahren - auf seiner Bauteiloberfläche mit einem maschinenlesbaren Code versehen ist, wobei der Code einteilig mit dem Bauteil ausgebildet ist und eine Vielzahl von dreidimensional gestalteten Code-Elementen aufweist, welche die kodierten Daten binär anhand von bezogen auf eine Bezugsebene erhabenen Bereichen und nicht-erhabenen Bereichen darstellen.

Darüber hinaus schafft die Erfindung eine Bauteil, das - beispielsweise mittels des oder der beschriebenen Verfahren - auf seiner Bauteiloberfläche mit einem maschinenlesbaren Code versehen ist, wobei der Code einteilig mit dem Bauteil ausgebildet ist und eine Vielzahl von dreidimensional gestalteten Code-Elementen aufweist, welche die kodierten Daten binär anhand von bezogen auf eine Bezugsebene vertieften Bereichen und nicht-vertieften Bereichen darstellen.

Die Code-Elemente sind bevorzugt in einer Reihen und Spalten definierenden Matrix angeordnet, insbesondere analog zu einem QR-Code.

Die Code-Elemente weisen vorteilhaft entweder eine einer ganzzahligen Quadratzahl entsprechende Anzahl von in einer regelmäßigen Matrix angeordneten erhabenen Bereichen bzw. von vertieften Bereichen auf oder bestehen aus einem einzelnen nicht-erhabenen Bereich bzw. nicht-vertieften Bereich.

Gemäß einer erfindungsgemäßen Ausgestaltung sind das Bauteil und der Code aus dem gleichen Ausgangswerkstoff hergestellt.

Bevorzugt sind die erhabenen Bereiche bzw. die vertieften Bereiche pyramidenförmig, pyramidenstumpfförmig, kegelförmig, kegelstumpfförmig oder kugelsegmentförmig ausgebildet.

Weitere Merkmale und Vorteile der vorliegenden Erfindung werden anhand der nachfolgenden Beschreibung erfindungsgemäßer Verfahren unter Bezugnahme auf die beiliegende Zeichnung deutlich. Darin ist
- Figur 1: eine perspektivische Teilansicht eines Bauteils, dessen Bauteiloberfläche mit einem Code gemäß einer ersten Ausführungsform der Erfindung versehen ist;
- Figur 2: eine perspektivische Teilansicht eines Bauteils, dessen Bauteiloberfläche mit einem Code gemäß einer zweiten Ausführungsform der Erfindung versehen ist;
- Figur 3: eine perspektivische Teilansicht eines Bauteils, dessen Bauteiloberfläche mit einem Code gemäß einer dritten Ausführungsform der Erfindung versehen ist;
- Figur 4: eine perspektivische Teilansicht eines Bauteils, dessen Bauteiloberfläche mit einem Code gemäß einer vierten Ausführungsform der Erfindung versehen ist;
- Figur 5: eine perspektivische Teilansicht eines Bauteils, dessen Bauteiloberfläche mit einem Code gemäß einer fünften Ausführungsform der Erfindung versehen ist; und
- Figur 6: eine schematische Ansicht eines Verfahrens gemäß einer Ausführungsform der vorliegenden Erfindung.

Gleich Bezugsziffern bezeichnen nachfolgend gleiche oder gleichartig ausgebildete Komponenten.

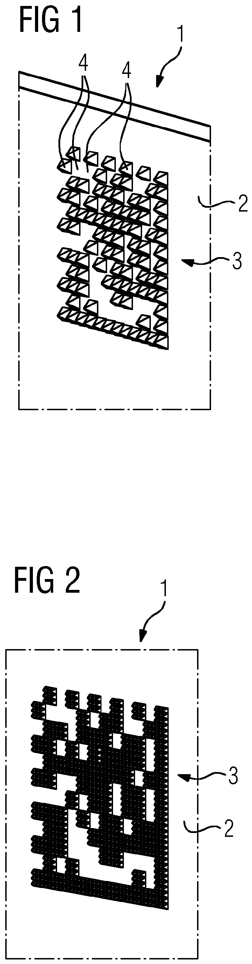

Figur 1 zeigt ein Bauteil 1, auf dessen Bauteiloberfläche 2 in einem funktional nicht relevanten Bereich ein Code 3 gemäß einer ersten Ausführungsform der vorliegenden Erfindung angeordnet ist, der als Identifikator des Bauteils 1 dienende Informationen sowie zusätzliche Informationen enthält, die insbesondere die Produktionsbedingungen des Bauteils betreffen, um auf diese Weise eine möglichst genaue Bauteilrückverfolgung zu ermöglichen. Der Code 3 ist einteilig mit dem und aus dem gleichen Ausgangswerkstoff wie das Bauteil 1 hergestellt und umfasst eine Vielzahl von dreidimensional gestalteten Code-Elementen 4, die nach Art eines QR-Codes in einer NxM-Matrix angeordnet sind, wobei N der Anzahl der Zeilen und M der Anzahl der Spalten entspricht. Vorliegend ist N=12 und M=12 gewählt, so dass sich insgesamt eine quadratische Matrix ergibt. Die Code-Elemente 4 stellen die kodierten Daten binär anhand von bezogen auf eine durch die Bauteiloberfläche 2 definierte Bezugsebene erhabenen Bereichen und nicht-erhabenen Bereichen dar, wobei die erhabenen Bereiche jeweils die Form einer Pyramide mit vier spitz zulaufenden Seitenwänden aufweisen. Dabei wird jedes Code-Element 4 entweder durch einen einzelnen erhabenen Bereich oder durch einen einzelnen nicht-erhabenen Bereich innerhalb der Bezugsebene gebildet. Dank der Pyramidenform der erhabenen Bereiche ist das Lichtreflexionsverhalten der erhabenen Bereiche deutlich von dem der nicht-erhabenen Bereiche zu unterscheiden, wodurch die maschinelle Auslesbarkeit des Codes 3 begünstigt wird. Zum Auslesen kann wie zum Auslesen eines QR-Codes beispielsweise ein Smartphone mit integrierter Kamera und entsprechender Software oder ein vergleichbares Auslesesystem verwendet werden.

Figur 2 zeigt ein Bauteil 1, auf dessen Bauteiloberfläche 2 in einem funktional nicht relevanten Bereich ein Code 3 gemäß einer zweiten Ausführungsform der vorliegenden Erfindung angeordnet ist. Dieser unterscheidet sich von dem in Figur 1 dargestellten Code lediglich dahingehend, dass jedes Code-Element entweder durch neun erhabene, in einer quadratischen Sub-Matrix angeordnete Bereiche oder durch einen einzelnen nicht erhabenen Bereich innerhalb der Bezugsebene gebildet wird, dessen Fläche der Fläche von neun erhabenen Bereichen in quadratischer Anordnung entspricht. Dies ist dahingehend von Vorteil, dass der Kontrast zwischen den aus erhabenen Bereichen bestehenden Code-Elementen 4 und den aus je einem nicht-erhabenen Bereich bestehenden Code-Elementen 4 noch deutlicher wird, was die maschinelle Auslesbarkeit des Codes 3 begünstigt. An dieser Stelle sei darauf hingewiesen, dass anstelle von 9 erhabenen Bereichen pro Code-Element 4 grundsätzlich auch eine andere Anzahl von in einer regelmäßigen Matrix angeordneten erhabenen Bereichen pro Code-Element 4 verwendet werden kann, die einer ganzzahligen Quadratzahl entspricht, also 4, 16, 25, ... erhabene Bereiche.

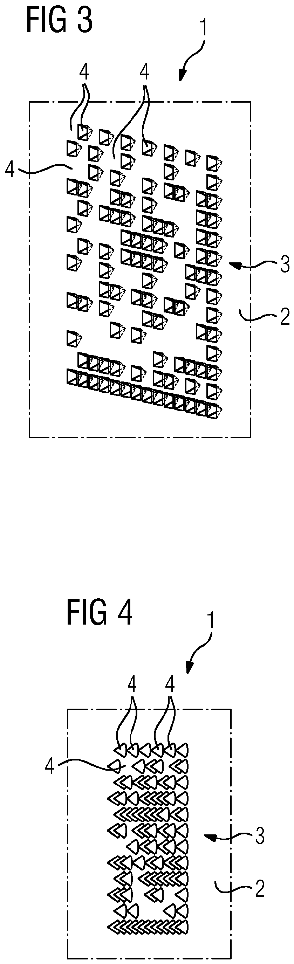

Figur 3 zeigt ein Bauteil 1, auf dessen Bauteiloberfläche 2 in einem funktional nicht relevanten Bereich ein Code 3 gemäß einer dritten Ausführungsform der vorliegenden Erfindung angeordnet ist. Dieser unterscheidet sich von dem in Figur 1 dargestellten Code 3 lediglich dahingehend, dass anstelle von pyramidenförmigen erhabenen Bereichen solche Bereiche vorgesehen sind, die gegenüber der durch die Bauteiloberfläche 2 definierten Bezugsebene pyramidenförmig vertieft sind. Ebenso ist eine Anordnung analog zu Figur 2 mit vertieften Bereichen anstelle von erhabenen Bereichen denkbar.

Figur 4 zeigt ein Bauteil 1, auf dessen Bauteiloberfläche 2 in einem funktional nicht relevanten Bereich ein Code 3 gemäß einer vierten Ausführungsform der vorliegenden Erfindung angeordnet ist. Dieser unterscheidet sich von dem in Figur 1 dargestellten Code 3 lediglich dahingehend, dass anstelle von pyramidenförmigen erhabenen Bereichen kegelförmige erhabene Bereiche vorgesehen sind. Auch wenn dies vorliegend nicht dargestellt ist, kann jedes Code-Element 4 analog zu Figur 2 eine Anzahl von in einer quadratischen Sub-Matrix angeordneten erhabenen Bereichen aufweisen, die einer ganzzahligen Quadratzahl entspricht, also 4, 9, 16, 25 ... erhabene Bereiche. Ebenso können die erhabenen Bereiche analog zu Figur 3 durch vertiefte Bereiche ersetzt werden.

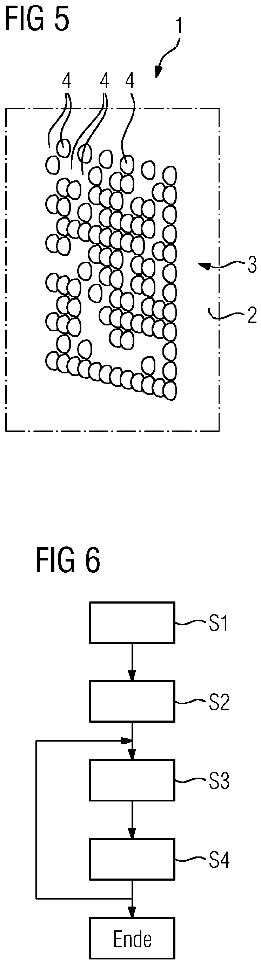

Figur 5 zeigt ein Bauteil 1, auf dessen Bauteiloberfläche 2 in einem funktional nicht relevanten Bereich ein Code 3 gemäß einer fünften Ausführungsform der vorliegenden Erfindung angeordnet ist. Dieser unterscheidet sich von dem in Figur 1 dargestellten Code 3 lediglich dahingehend, dass anstelle von pyramidenförmigen erhabenen Bereichen kugelsegmentförmige erhabene Bereiche vorgesehen sind. Auch wenn dies vorliegend nicht dargestellt ist, kann jedes Code-Element 4 analog zu Figur 2 eine Anzahl von in einer quadratischen Sub-Matrix angeordneten erhabenen Bereichen aufweisen, die einer ganzzahligen Quadratzahl entspricht, also 4, 9, 16, 25 ... erhabene Bereiche. Ebenso können die erhabenen Bereiche analog zu Figur 3 durch vertiefte Bereiche ersetzt werden.

Die in den Figuren 1 bis 5 dargestellten Bauteile zeichnen sich dadurch aus, dass die Codes 3 jeweils einteilig mit diesen hergestellt werden, so dass die Codes 3 nicht ohne weiteres von dem Bauteil 1 getrennt oder manipuliert werden können. Die dreidimensionalen Codes 3 nach Art eines QR-Codes können eine Vielzahl von Informationen beinhalten und sind in einfacher Weise maschinell auslesbar.

Figur 6 zeigt schematisch ein Verfahren gemäß einer Ausführungsform der vorliegenden Erfindung, mit dem eines der in den Figuren 1 bis 5 dargestellten Bauteile 1 einschließlich seines Codes 3 in Serie hergestellt werden kann.

In einem Schritt S1 wird unter Verwendung eines Rechners ein 3D-CAD-Datensatz erstellt, der das Bauteil 1 einschließlich des Codes 3 abbildet und auf einer additiven Fertigungsmaschine verarbeitet werden kann. Der 3D-CAD-Datensatz weist die Geometrie des Bauteils definierende Daten, die Position des Codes auf der Bauteiloberfläche betreffende Daten und die Geometrie des Codes betreffende Daten auf oder besteht aus diesen Daten.

In einem zweiten Schritt S2 werden das Bauteil 1 und der Code 3 auf Basis des in Schritt S1 erstellten 3D-CAD-Datensatzes schichtweise auf einer additiven Fertigungsmaschine gefertigt.

In einem Schritt S3 wird ein neuer 3D-CAD-Datensatz für das nächste der in Serie zu fertigenden Bauteile 1 einschließlich des zugehörigen Codes 3 erstellt. Dabei werden die die Geometrie des Bauteils definierende Daten und die die Position des Codes auf der Bauteiloberfläche betreffende Daten des in Schritt S1 erstellten 3D-CAD-Datensatzes übernommen und lediglich die die Geometrie des Codes betreffenden Daten durch neue ersetzt.

In einem Schritt S4 werden dann das Bauteil 1 und der Code 3 auf Basis des in Schritt S3 erstellten 3D-CAD-Datensatzes schichtweise auf einer additiven Fertigungsmaschine gefertigt.

Die Schritte S3 und S4 werden dann in Abhängigkeit von der Anzahl der in Serie zu fertigenden Bauteile 1 wiederholt.

Das zuvor beschriebene Verfahren zeichnet sich dadurch aus, dass das Bauteil 1 und der zugehörige Code 3 in einem einzelnen Arbeitsschritt gefertigt werden können. Dabei ist stets eine dauerhaft ordnungsgemäße Zuordnung von Bauteil 1 und Code 3 gewährleistet.

Alternativ wird in Schritt S1 unter Verwendung eines Rechners ein 3D-CAD-Datensatz erstellt, der das Bauteil 1 und die Position des Codes 3 auf dem Bauteil 1 abbildet und auf einer additiven Fertigungsmaschine verarbeitet werden kann. Der 3D-CAD-Datensatz weist also die Geometrie des Bauteils definierende Daten und die Position des Codes auf der Bauteiloberfläche betreffende Daten auf oder besteht aus diesen Daten. Ferner werden diesem erstellten 3D-CAD-Datensatz in Schritt S1 die Geometrie des Codes 3 betreffende Daten durch eine CAM-Software hinzugefügt.

In einem zweiten Schritt S2 werden das Bauteil 1 und der Code 3 auf Basis der in Schritt 1 erstellten Daten schichtweise auf einer additiven Fertigungsmaschine gefertigt.

Im Schritt S3 werden dem 3D-CAD-Datensatz aus Schritt 1 geänderte, die Geometrie des Codes 3 betreffende Daten durch eine CAM-Software hinzugefügt.

Im Schritt S4 werden dann das Bauteil 1 und der Code 3 auf Basis der in Schritt S3 erstellten Daten schichtweise auf einer additiven Fertigungsmaschine gefertigt.

Die Schritte S3 und S4 werden dann in Abhängigkeit von der Anzahl der in Serie zu fertigenden Bauteile 1 wiederholt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren, bei dem ein dreidimensionales Bauteil (1) hergestellt und auf seiner Bauteiloberfläche (2) mit einem maschinenlesbaren Code (3) versehen wird,
**dadurch gekennzeichnet, dass**
der Code (3) einteilig mit dem Bauteil (1) und aus dem gleichen Ausgangswerkstoff hergestellt wird und eine Vielzahl von dreidimensional gestalteten Code-Elementen (4) aufweist, welche die kodierten Daten binär anhand von bezogen auf eine Bezugsebene erhabenen Bereichen und nicht-erhabenen Bereichen darstellen, wobei das Bauteil (1) und der Code (3) auf Basis eines 3D-CAD-Datensatzes schichtweise auf einer additiven Fertigungsmaschine gefertigt werden, wobei der 3D-CAD-Datensatz die Geometrie des Bauteils (1) definierende Daten und die Position des Codes (3) auf der Bauteiloberfläche (2) betreffende Daten aufweist oder aus diesen Daten besteht, und wobei dem 3D-CAD-Datensatz vor der additiven Fertigung die Geometrie des Codes (3) betreffende Daten durch eine CAM-Software hinzugefügt werden.

2. Verfahren, bei dem ein dreidimensionales Bauteil (1) hergestellt und auf seiner Bauteiloberfläche (2) mit einem maschinenlesbaren Code (3) versehen wird,
**dadurch gekennzeichnet, dass**
der Code (3) einteilig mit dem Bauteil (1) und aus dem gleichen Ausgangswerkstoff hergestellt wird und eine Vielzahl von dreidimensional gestalteten Code-Elementen (4) aufweist, welche die kodierten Daten binär anhand von bezogen auf eine Bezugsebene vertieften Bereichen und nicht-vertieften Bereichen darstellen, wobei das Bauteil (1) und der Code (3) auf Basis eines 3D-CAD-Datensatzes schichtweise auf einer additiven Fertigungsmaschine gefertigt werden, wobei der 3D-CAD-Datensatz die Geometrie des Bauteils (1) definierende Daten und die Position des Codes (3) auf der Bauteiloberfläche (2) betreffende Daten aufweist oder aus diesen Daten besteht, und wobei dem 3D-CAD-Datensatz vor der additiven Fertigung die Geometrie des Codes (3) betreffende Daten durch eine CAM-Software hinzugefügt werden.

3. Verfahren nach einem der vorhergehenden Ansprüche,
**dadurch gekennzeichnet, dass**
die Code-Elemente (4) in einer Reihen und Spalten definierenden Matrix angeordnet sind, insbesondere analog zu einem QR-Code.

4. Verfahren nach einem der vorhergehenden Ansprüche,
**dadurch gekennzeichnet, dass**
die Code-Elemente (4) entweder eine einer ganzzahligen Quadratzahl entsprechende Anzahl von in einer regelmäßigen Matrix angeordneten erhabenen Bereichen bzw. von vertieften Bereichen aufweisen oder aus einem einzelnen nicht-erhabenen Bereich bzw. nicht-vertieften Bereich bestehen.

5. Verfahren nach einem der vorhergehenden Ansprüche,
**dadurch gekennzeichnet, dass**
die erhabenen Bereiche bzw. die vertieften Bereiche pyramidenförmig, pyramidenstumpfförmig, kegelförmig, kegelstumpfförmig oder kugelsegmentförmig ausgebildet sind.

6. Verfahren nach einem der der vorhergehenden Ansprüche,
**dadurch gekennzeichnet, dass**
das Bauteil in Serie gefertigt wird, wobei nach der Fertigung jedes Bauteils ausschließlich die Geometrie des Codes (3) betreffende Daten geändert werden.

## Claims

1. Method in which a three-dimensional component (1) is manufactured and is provided with a machine-readable code (3) on its component surface (2),
**characterized in that**
the code (3) is manufactured as one piece with the component (1) and from the same starting material, and comprises a plurality of three-dimensionally designed code elements (4) which depict the encoded data in a binary format, using raised areas and non-raised areas with reference to a reference plane, wherein the component (1) and the code (3) are produced layer by layer on an additive production machine on the basis of a 3D-CAD dataset, wherein the 3D-CAD dataset comprises data defining the geometry of the component (1) and data relating to the position of the code (3) on the component surface (2), or is made up of these data, and wherein data relating to the geometry of the code (3) are added to the 3D-CAD dataset by means of CAM software before the additive production.

2. Method in which a three-dimensional component (1) is manufactured and is provided with a machine-readable code (3) on its component surface (2),
**characterized in that**
the code (3) is manufactured as one piece with the component (1) and from the same starting material, and comprises a plurality of three-dimensionally designed code elements (4) which depict the encoded data in a binary format, using recessed areas and non-recessed areas with reference to a reference plane, wherein the component (1) and the code (3) are produced layer by layer on an additive production machine on the basis of a 3D-CAD dataset, wherein the 3D-CAD dataset comprises data defining the geometry of the component (1) and data relating to the position of the code (3) on the component surface (2), or is made up of these data, and wherein data relating to the geometry of the code (3) are added to the 3D-CAD dataset by means of CAM software before the additive production.

3. Method according to one of the preceding claims,
**characterized in that**
the code elements (4) are arranged in a matrix defining rows and columns, in particular analogously to a QR code.

4. Method according to one of the preceding claims,
**characterized in that**
the code elements (4) comprise either a number of raised areas or recessed areas which are arranged in a regular matrix and which correspond to an integer number of squares, or are made up of a single non-raised area or non-recessed area.

5. Method according to one of the preceding claims,
**characterized in that**
the raised areas and the recessed areas are formed in a pyramidal, frustopyramidal, conical, frustoconical or spherical segment shape.

6. Method according to one of the preceding claims,
**characterized in that**
the component is produced in series, wherein only data relating to the geometry of the code (3) are changed after the production of each component.

## Revendications

1. Procédé, dans lequel on produit un composant (1) en trois dimensions et on munit sa surface (2) de composant d'un code (3) déchiffrable par machine,
**caractérisé en ce que**
l'on produit le code (3) d'une pièce avec le composant (1) et en le même matériau de départ et il a une pluralité d'éléments (4) de code conformés en trois dimensions, qui représentent les données codées d'une manière binaire, à l'aide de parties en saillie et de parties qui ne sont pas en saillie par rapport à un plan de référence, dans lequel on fabrique le composant (1) et le code (3) sur la base d'un ensemble de données CAD en 3D, couche par couche, sur une machine de fabrication additive, dans lequel l'ensemble de données CAD en 3D a des données définissant la géométrie du composant (1) et des données concernant la position du code (3) sur la surface (2) du composant ou est constitué de ces données, et dans lequel on ajoute, par un logiciel CAM, à l'ensemble de données CAD en 3D, avant la fabrication additive, des données concernant la géométrie du code (3).

2. Procédé, dans lequel on produit un composant (1) en trois dimensions et on munit sa surface (2) de composant d'un code (3) déchiffrable par machine,
**caractérisé en ce que**
l'on produit le code (3) d'une pièce avec le composant (1) et en le même matériau de départ et il a une pluralité d'éléments (4) de code conformés en trois dimensions, qui représentent les données codées de manière binaire, à l'aide de parties creusées et de parties non creusées par rapport à un plan de référence, et dans lequel on fabrique le composant (1) et le code (3), sur la base d'un ensemble de données CAD en 3D, couche par couche, sur une machine de fabrication additive, dans lequel l'ensemble de données CAD en 3D a des données définissant la géométrie du composant (1) et des données concernant la position du code (3) sur la surface (2) du composant ou est constitué de ces données, et dans lequel on ajoute, par un logiciel CAM, à l'ensemble de données CAD en 3D, avant la fabrication additive, des données concernant la géométrie du code (3).

3. Procédé suivant l'une des revendications précédentes,
**caractérisé en ce que**
les éléments (4) de code sont disposés suivant une matrice définissant des rangées et des colonnes, notamment d'une manière analogue à un code QR.

4. Procédé suivant l'une des revendications précédentes,
**caractérisé en ce que**
les éléments (4) de code ont, soit un nombre correspondant à un nombre entier au carré, de parties en saillie ou de parties creusées disposées suivant une matrice régulière, soit sont constitués d'une partie individuelle, qui n'est pas en saillie ou qui n'est pas creusée.

5. Procédé suivant l'une des revendications précédentes,
**caractérisé en ce que**
les parties en saillie ou les parties creusées sont constituées en forme de pyramide, en forme de tronc de pyramide, en forme de cône, en forme de tronc de cône ou en forme de segment de cône.

6. Procédé suivant l'une des revendications précédentes,
**caractérisé en ce que**
l'on fabrique le composant en série, dans lequel, après la fabrication de chaque composant, on modifie exclusivement des données concernant la géométrie du code (3).
